# EUROPEAN PATENT SPECIFICATION

(11) **EP 0 766 400 B1**
(45) Date of publication and mention of the grant of the patent: **10.04.2002**
(21) Application number: 96115290.7
(22) Date of filing: 24.09.1996
(51) Int. Cl.: H03K 19/003

(54) **Output stage resistant to external overvoltages on its output where powered down in high impedance state**
Ausgangsstufe mit Schutz gegen externe Überspannungen am Ausgang im abgeschalteten, hochimpedanten Zustand
Etage de sortie supportant des surtensions extérieures appliquées sur sa sortie dans l'état haute impédance et non-alimenté

(30) Priority: 26.09.1995 US 4335
(43) Date of publication of application: 02.04.1997
(73) Proprietor: TEXAS INSTRUMENTS INCORPORATED, Dallas, Texas 75243 (US)
(72) Inventor: Yaklin, Daniel, Garland, TX 75044 (US); Johnson, David K., Plano, TX 75025 (US); Wetzel, Alan, Parker, TX 75002 (US)
(74) Representative: Holt, Michael

(56) References cited:
- EP-A- 0 480 201
- EP-A- 0 498 377
- US-A- 5 387 826

## Description

### FIELD OF THE INVENTION

This invention generally relates to electronic systems and in particular it relates to circuitry for providing a high impedance state when powering down a single port node.

### BACKGROUND OF THE INVENTION

In IEEE P1394 network systems, single port devices are coupled to a multi port device. When one of the single port devices is powered down, it can provide a low impedance node which can pull down a bias line from the multi port device. This can cause the entire network to not operate properly. In the prior art,, relays or switches have been used to isolate the powered down device from the rest of the network.

European Patent Application EP-A-0,498,377 discloses a CMOS output circuit which provides a high impedance output node when a higher voltage than the voltage on the power supply line is applied to the output terminal. This means the CMOS output circuit provides a high impedance output node when it is powered down. United States Patent 5,387,826 discloses an output driver of a module connected to a bus. This output driver does not provide a leakage path from the bus when the module is powered down. This means that the output driver has a high impedance output node when powered down.

### SUMMARY OF THE INVENTION

Generally, and in one form of the invention, a network circuit has a single port device having a high impedance output node when the single port device is powered down; and a multi port device having a bias node coupled to the output node.

According to a preferred form of the invention, there is provided a driver circuit having a high impedance output node when powered-down. This driver circuit comprises a first transistor having a drain that is coupled to the output node; a second transistor that has a drain coupled to the back-gate of the first transistor; a third transistor having a drain coupled to the back-gate of the first transistor, a source coupled to the gate of the second transistor, and a gate coupled to the source of the second transistor; and a fourth transistor that has a drain coupled to the gate of the second transistor, and a gate coupled to the source of the second transistor. The coupling of drain of the first transistor to the output node, and the circuitry coupled to the back-gate reduce current flow from the drain to the back-gate.

### BRIEF DESCRIPTION OF THE DRAWINGS

The present invention will now be further described, by way of example, with reference to the accompanying drawings in which:
FIG. 1 is a network schematic of an IEEE P1394 system
FIG. 2 is a circuit diagram of a P channel transistor with a diode coupled to the back gate ass found in the drivers of Figure 1;
FIG. 3 is a semiconductor cross section of the circuit of FIG. 2;
FIG. 4 is the circuit of FIG. 2 with an additional transistor;
FIG. 5 is a circuit diagram of a P channel transistor with back gate circuitry; and
FIG. 6 is a circuit diagram of a preferred embodiment driver circuit.

### DETAILED DESCRIPTION OF PREFERRED EMBODIMENTS

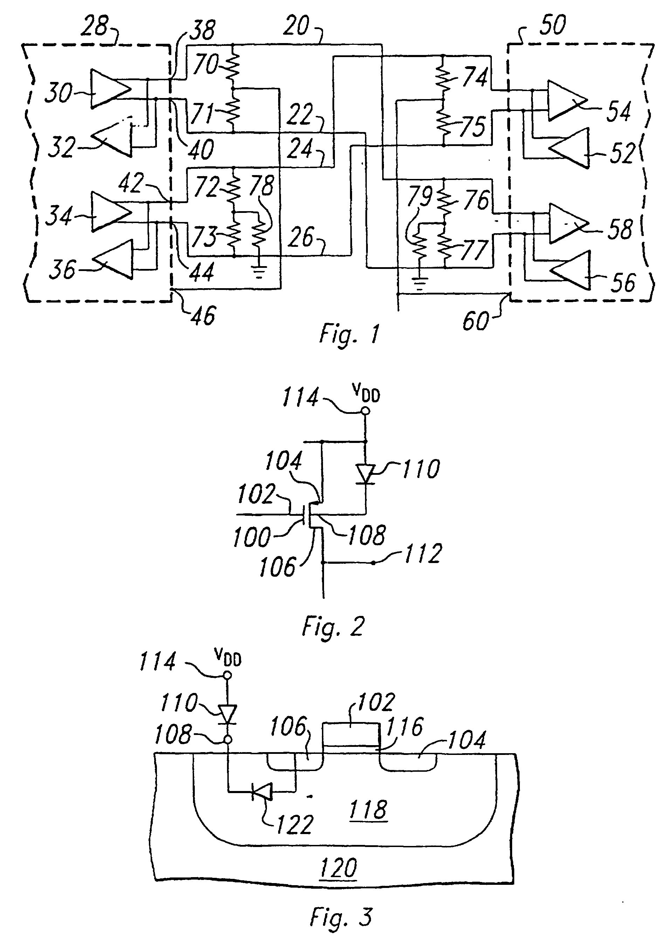

Shown in Figure 1 is a network schematic of an IEEE P1394 system. The system includes twisted pair A (TPA) which includes lines 20 and 22; twisted pair B (TPB) which includes lines 24 and 26; single port physical layer device 28 which includes TPA driver 30, TPA receiver 32, TPB driver 34, TPB receiver 36, TPA nodes 38 and 40, TPB nodes 42 and 44, and TP bias node 46; multi port physical layer device 50 which includes TPA driver 52, TPA receiver 54, TPB driver 56, TPB receiver 58, and TP bias node 60; and resistors 70-79. In the preferred embodiment, resistors 70-77 have a resistance of 55 ohms and resistors 78 and 79 have a resistance of 5K ohms.

When the single port device 28 is powered down and does not receive cable power to keep the device operating, the powered down device 28 pulls down the TP bias from node 60 on the device it is connected to (multi port device 50). This causes the other ports of multi port device 50 to not operate properly and can bring down the entire network. In the prior art, a relay or switch was used to isolate the powered down device from the rest of the network.

When the single port device 28 is powered down, a low input impedance exists on the TPB nodes 42 and 44. This low impedance is created by the TPA and TPB drivers 30 and 34. TP bias from node 60 is coupled to node 42 through resistor 74 (55 ohms in the preferred embodiment). This creates a low impedance which can overload the TP bias from node 60 of the multi port device 50. The preferred embodiment solves this low impedance problem by providing a high impedance at the TPA and TPB nodes 38, 40, 42, and 44 when the device 28 is powered down.

The source of the low impedance is P channel devices, such as shown in Figures 2 and 3, within the drivers 30 and 34 connected to the TPA and TPB nodes 38, 40, 42, and 44. Figure 2 is a circuit diagram of a P channel transistor 100 as found in drivers 30 and 34. P channel transistor 100 is the semiconductor device shown in Figure 3. The circuit of Figure 2 includes transistor 100, gate 102, source 104, drain 106, back gate 108, diode 110, TPA/TPB node 112, and V_{DD} node 114. The semiconductor device of Figure 3 includes gate 102, P type drain 106, P type source 104, insulator region 116, N type region 118, P type region 120, back gate node 108, diode 110, V_{DD} node 114, and parasitic diode 122. The low impedance path is from the drain 106 to the back gate connection 108, which is tied to V_{DD}. The low impedance occurs when V_{DD} is powered down and current flow is in the direction from the drain 106 to the back gate 108. By inserting a series diode 110 between the back gate 108 and the V_{DD} node 114, the problem is solved.

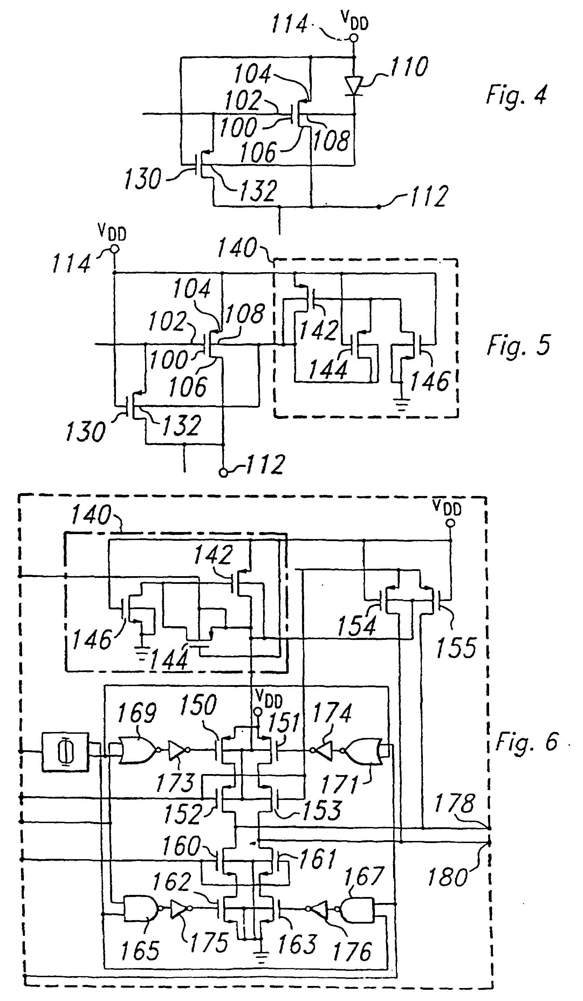

Another potential path exists through the drain 106 to source 104 path. If the voltage on gate 102 stays low, the transistor 100 can still turn on when the voltage on drain 106 is raised. To solve this problem, another P channel transistor 130 can be added to bias up the gate 102 to the potential on the TPA or TPB nodes, as shown in Figure 4. The circuit in Figure 4 includes transistor 130 coupled to the circuit of Figure 2. The back gate 132 of transistor 130 is also coupled to diode 110 to prevent a low impedance path through transistor 130.

A second embodiment, shown in Figure 5, provides another solution to the back gate problem. The circuit of Figure 5 includes transistors 100 and 130 of Figure 4 along with circuit 140, which takes the place of diode 110 in Figure 4. Circuit 140 includes transistors 142, 144, and 146. This circuit provides a high impedance at the drain 106 when V_{DD} is powered down. The circuit in Figure 5 can provide back gate bias to all P channels in the driver, especially if multiple P channels are in the same tank.

A preferred embodiment driver circuit is shown in Figure 6. This circuit uses the back gate circuit 140, shown in Figure 5. The driver circuit includes back gate circuit 140, P channel transistors 150-155, N channel transistors 160-163, nand gates 165 and 167, nor gates 169 and 171, inverters 173-176, and TPA nodes 178 and 180. The back gate circuit 140 is coupled to the back gates of all P channel transistors 150-155 in the driver circuit. Transistors 154 and 155 serve the same purpose as transistor 130 in Figures 4 and 5.

A particularly preferred embodiment of each of the driver circuits of Figures 2, 4, 5 & 6 uses MOSFET devices.

Preferred embodiments have been described in detail hereinabove. It is to be understood that the scope of the invention also comprehends embodiments different from that described. For example, transmission gates can be used to help isolate the circuit under power down conditions.

## Claims

1. A driver circuit for providing a high impedance output node (112) when powered-down, which driver circuit comprising:
a first transistor (100) having a source (104), a drain (106), a gate (102), and a back-gate (108), said first transistor (100) arranged such that said drain (106) is coupled to said output node (112);
a second transistor (142) having a source, a drain, and a gate, said second transistor (142) being arranged such that said drain thereof is coupled to said back-gate (108) and that said source thereof is coupled to the source of the first transistor;
a third transistor (144) having a source, a drain, and a gate, said third transistor (144) being arranged such that said drain thereof is coupled to said back-gate (108), said source thereof is coupled to said gate of said second transistor (142), and said gate thereof is coupled to said source of said second transistor (142);
a fourth transistor (146) having a source, a drain, and a gate, said fourth transistor (146) being arranged such that said drain thereof is coupled to said gate of said second transistor (142), and said gate thereof is coupled to said source of said second transistor (142),
whereby said first, second and third transistor are of a first type and whereby said fourth transistor is of a second opposite type.

2. The driver circuit as claimed in Claim 1 further comprising:
circuitry (130) coupled to said gate (102) of said first transistor for biasing the gate (102) to a potential on said output node (112) to minimize current flow from said drain (106) to said source (104) of said first transistor (100).

3. The driver circuit as claimed in Claim 2, wherein said circuitry coupled to said gate (102) of said first transistor (100) comprises:
a fifth transistor (130) having a source coupled to the gate (102) of the first transistor (100), and a drain coupled to said output node (112).

4. The driver circuit as claimed in any preceding claim, wherein said driver circuit is a single port device that is capable of being coupled to a multi-port device.

5. The driver circuit as claimed in Claim 4, wherein said output node (112) is capable of being coupled to a bias node of said multi-port device through a resistor.

6. The driver circuit as claimed in any preceding claim, wherein said first transistor (100), said second transistor (142), said third transistor (144), and said fourth transistor (146) are MOSFETs.

7. The driver circuit as claimed in Claim 6, wherein said first transistor (100), said second transistor (142), and said third transistor (144) are P-channel MOSFETs.

8. The driver circuit as claimed in Claim 6 or Claim 7, wherein said fourth transistor (146) is an N-channel MOSFET.

## Patentansprüche

1. Treiberschaltung zur Erzeugung eines hochohmigen Ausgangsschaltungspunkt (112) im abgeschalteten Zustand, wobei die Treiberschaltung enthält:
einen ersten Transistor (100) mit einem Source-Anschluß (104), einem Drain-Anschluß (106), einem Gate-Anschluß (102) und einem Substrat-Anschluß (108), wobei der erste Transistor (100) so angeordnet ist, daß der Drain-Anschluß (106) mit dem Ausgangsschaltungspunkt (112) verbunden ist;
einen zweiten Transistor (142) mit einem Source-Anschluß, einem Drain-Anschluß und einem Gate-Anschluß, wobei der zweite Transistor (142) so angeordnet ist, daß sein Drain-Anschluß mit dem Substrat-Anschluß (108) verbunden ist und daß sein Source-Anschluß mit dem Source-Anschluß des ersten Transistors verbunden ist;
einen dritten Transistor (144) mit einem Source-Anschluß, einem Drain-Anschluß und einem Gate-Anschluß, wobei der dritte Transistor (144) so angeordnet ist, daß sein Drain-Anschluß mit dem Substrat-Anschluß (108) verbunden ist, sein Source-Anschluß mit dem Gate-Anschluß des zweiten Transistors (142) verbunden ist und sein Gate-Anschluß mit dem Source-Anschluß des zweiten Transistors (142) verbunden ist;
einen vierten Transistor (146) mit einem Source-Anschluß, einem Drain-Anschluß und einem Gate-Anschluß, wobei der vierte Transistor (146) so angeordnet ist, daß sein Drain-Anschluß mit dem Gate-Anschluß des zweiten Transistors (142) verbunden ist und sein Gate-Anschluß mit dem Source-Anschluß des zweiten Transistors (142) verbunden ist, wobei der erste, der zweite und der dritte Transistor Transistoren eines ersten Typs sind und wobei der vierte Transistor ein Transistor eines zweiten, entgegengesetzten Typs ist.

2. Treiberschaltung nach Anspruch 1, ferner mit:
einer mit dem Gate-Anschluß (102) des ersten Transistors verbundenen Schaltungsanordnung (130) zum Vorspannen des Gate-Anschlusses (102) auf ein Potential an dem Ausgangsschaltungspunkt (112), um den Stromfluß von dem Drain-Anschluß (106) zu dem Source-Anschluß (104) des ersten Transistors (100) zu minimieren.

3. Treiberschaltung nach Anspruch 2, bei dem die mit dem Gate-Anschluß (102) des ersten Transistors (100) verbundene Schaltungsanordnung enthält:
einen fünften Transistor (130) mit einem mit dem Gate-Anschluß (102) des ersten Transistors (100) verbundenen Source-Anschluß und einem mit dem Ausgangsschaltungspunkt (112) verbundenen Drain-Anschluß.

4. Treiberschaltung nach einem der vorhergehenden Ansprüche, bei dem die Treiberschaltung eine Vorrichtung mit Einfachanschluß ist, die mit einer Mehrfachvorrichtung gekoppelt werden kann.

5. Treiberschaltung nach Anspruch 4, bei der der Ausgangsschaltungspunkt (112) mit einem Vorspannungsschaltungspunkt der Vorrichtung mit Mehrfachanschluß über einen Widerstand gekoppelt werden kann.

6. Treiberschaltung nach einem der vorhergehenden Ansprüche, bei der der erste Transistor (100), der zweite Transistor (142), der dritte Transistor (144) und der vierte Transistor (146) MOSFETs sind.

7. Treiberschaltung nach Anspruch 6, bei der der erste Transistor (100), der zweite Transistor (142) und der dritte Transistor (144) P-Kanal-MOSFETs sind.

8. Treiberschaltung nach Anspruch 6 oder Anspruch 7, bei der der vierte Transistor (146) ein N-Kanal-MOSFET ist.

## Revendications

1. Circuit pilote pour former un noeud de sortie de haute impédance (112) lorsque son alimentation est coupée, ledit circuit pilote comprenant :
un premier transistor (100) ayant une source (104), un drain (106), une grille (102) et une post-grille (108), ledit premier transistor (100) étant agencé de sorte que ledit drain (106) soit couplé audit noeud de sortie (112);
un deuxième transistor (142) ayant une source, un drain et une grille, ledit deuxième transistor (142) étant agencé de sorte que son dit drain soit couplé à ladite post-grille (108) et que sa dite source soit couplée à la source du premier transistor;
un troisième transistor (144) ayant une source, un drain et une grille, ledit troisième transistor (144) étant agencé de sorte que son dit drain soit couplé à ladite post-grille (108), que sa dite source soit couplée à ladite grille dudit deuxième transistor (142) et que sa dite grille soit couplée à ladite source dudit deuxième transistor (142);
un quatrième transistor (146) ayant une source, un drain et une grille, ledit quatrième transistor (146) étant agencé de sorte que son dit drain soit couplé à ladite grille dudit deuxième transistor (142) et que sa dite grille soit couplée à ladite source dudit deuxième transistor (142),
de sorte que lesdits premier, deuxième et troisième transistors soient d'un premier type et que ledit quatrième transistor soit d'un second type opposé.

2. Circuit pilote selon la revendication 1, comprenant en outre :
des circuits (130) couplés à ladite grille (102) dudit premier transistor pour polariser la grille (102) à un potentiel sur ledit noeud de sortie (112) pour minimiser le flux de courant dudit drain (106) à ladite source (104) dudit premier transistor (100).

3. Circuit pilote selon la revendication 2, dans lequel lesdits circuits couplés à ladite grille (102) dudit premier transistor (100) comprennent :
un cinquième transistor (130) ayant une source couplée à la grille (102) du premier transistor (100) et un drain couplé audit noeud de sortie (112).

4. Circuit pilote selon l'une quelconque des revendications précédentes, dans lequel ledit circuit pilote est un dispositif à port unique qui est à même d'être couplé à un dispositif à ports multiples.

5. Circuit pilote selon la revendication 4, dans lequel ledit noeud de sortie (112) est à même d'être couplé à un noeud de polarisation dudit dispositif à ports multiples par une résistance.

6. Circuit pilote selon l'une quelconque des revendications précédentes, dans lequel ledit premier transistor (110), ledit deuxième transistor (142), ledit troisième transistor (144) et ledit quatrième transistor (146) sont des MOSFET.

7. Circuit pilote selon la revendication 6, dans lequel ledit premier transistor (100), ledit deuxième transistor (142) et ledit troisième transistor (144) sont des MOSFET à canal P.

8. Circuit pilote selon la revendication 6 ou 7, dans lequel ledit quatrième transistor (146) est un MOSFET à canal N.
